# EUROPEAN PATENT APPLICATION

(11) **EP 3 062 337 A1**
(43) Date of publication of application: **31.08.2016**
(21) Application number: 14856663.1
(22) Date of filing: 21.10.2014
(51) Int. Cl.: H01L 21/304, B24B 37/00, C09G 1/02, C09K 3/14

(54) **POLISHING LIQUID COMPOSITION FOR SILICON WAFERS**

(30) Priority: 25.10.2013 JP 2013222541
(71) Applicant: Kao Corporation, Chuo-ku Tokyo 103-8210 (JP)
(72) Inventor: UCHIDA Yohei, Wakayama 640-8580 (JP); NISHIDA Kazuhiro, Wakayama 640-8580 (JP)
(74) Representative: Hoffmann Eitle
(86) International application number: PCT/JP2014/077924
(87) International publication number: WO 2015/060293

(57) **Abstract**

A polishing composition for a silicon wafer of the present invention includes: 0.01 to 0.5 mass% of silica particles; a nitrogen-containing basic compound; and a water-soluble polymer, wherein the water-soluble polymer includes a constitutional unit represented by a general formula (1) below: 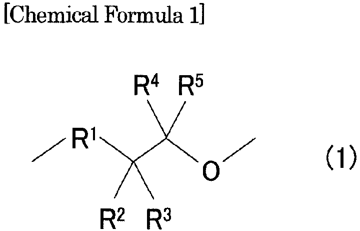 and in the water-soluble polymer, a ratio of the number of oxygen atoms derived from hydroxyl groups to the number of oxygen atoms derived from polyoxyalkylene (the number of oxygen atoms derived from hydroxyl groups / the number of oxygen atoms derived from polyoxyalkylene) is in a range from 0.8 to 10. The water-soluble polymer is preferably at least one kind selected from the group consisting of polyglycidol, a polyglycidol derivative, polyglycerin, a polyglycerin derivative, and a polyvinyl alcohol-polyethylene glycol graft copolymer having polyvinyl alcohol as a side chain.

## Description

### Technical Field

The present invention relates to a polishing composition for a silicon wafer and a method for manufacturing a semiconductor substrate using the same, and a method for polishing a silicon wafer.

### Background Art

Recently, the design rule for semiconductor devices have become more minute due to the increasing demand for the trend of higher recording capacity of a semiconductor memory. As a result, in a photolithography performed in the process of manufacturing the semiconductor device, the depth of focus is decreased, and the demand for the defect reduction and smoothness of silicon wafer (bare wafer) has become even further strict.

For improving the quality of a silicon wafer, polishing of the silicon wafer is performed in multi-stages. In particular, a final polishing performed in the final stage of the polishing is performed to suppress the surface roughness (haze) and also suppress surface defects (LPD: Light Point Defects) such as particles, scratches and pits, which is achieved by improving wettability (hydrophilicity) of the polished silicon wafer surface.

As a polishing composition used for the final polishing, a polishing composition for chemical-mechanical polishing containing colloidal silica and an alkali compound is known. Furthermore, as a polishing composition for improving the haze level, a polishing composition for chemical-mechanical polishing containing colloidal silica, hydroxyethylcellulose (HEC), and polyethylene oxide (PEO) is known (Patent Document 1).

Meanwhile, as a polishing composition for decreasing the number of surface defects (LPD), a polishing composition whose sodium or acetate ion concentration is controlled at 10 ppb or less by subjecting a polyvinyl alcohol aqueous solution to ion exchange is known (Patent Document 2). As a polishing composition for improving waviness and/or haze, a polishing composition containing a chain hydrocarbon-based polymer having a carbon long chain structure and a hydroxy lower alkoxy group as a side chain (e.g., ethylene oxide adduct polyvinyl alcohol) is known (Patent Document 3). As a polishing composition used for planarizing the surface of a semiconductor wafer having steps, a polishing composition including polyvinyl alcohols as an agent for eliminating steps is known (Patent Document 4).

### Prior Art Documents

### Patent Documents

Patent Document 1: JP 2004-128089 A
Patent Document 2: JP 2008-53414 A
Patent Document 3: JP 1999(H11)-140427 A
Patent Document 4: WO 2011/093223

### Disclosure of Invention

### Problem to be Solved by the Invention

The polishing composition produced using HEC includes water-insoluble matters derived from cellulose because HEC is made of natural cellulose. Such water-insoluble matters are prone to become cores of aggregation of silica particles, and the presence of the aggregates of silica particles and the water-insoluble matters themselves may increase the surface defects (LPD).

Moreover, polishing using the polishing compositions of Patent Documents 2-4 cannot sufficiently reduce the surface roughness (haze) and the surface defects (LPD) of a silicon wafer at the same time.

Therefore, the present invention provides: a polishing composition for a silicon wafer, which can reduce both of the surface roughness (haze) and the surface defects (LPD) of a silicon wafer; a method for manufacturing a semiconductor substrate using the polishing composition for a silicon wafer; and a method for polishing a silicon wafer.

### Means for Solving Problem

The polishing composition for a silicon wafer of the present invention contains components A-C below.

### (Component A) silica particles

### (Component B) nitrogen-containing basic compound

### (Component C) water-soluble polymer

The content of the silica particles in the polishing composition for a silicon wafer is 0.01 to 0.5 mass%, and the water-soluble polymer (component C) includes a constitutional unit represented by a general formula (1) below: 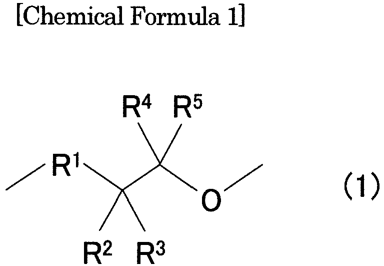 (wherein, in the above general formula (1),
R¹ is a methylene group (-CH₂-) or a bond, and
R², R³, R⁴ and R⁵ each independently represent H (hydrogen atom), -OH (hydroxyl group), -CH₂OH or polyvinyl alcohol, where all of R², R³, R⁴ and R⁵ do not simultaneously represent H (hydrogen atom), -OH (hydroxyl group) or -CH₂OH), and
in the water-soluble polymer, a ratio of the number of oxygen atoms derived from hydroxyl groups to the number of oxygen atoms derived from polyoxyalkylene (the number of oxygen atoms derived from hydroxyl groups / the number of oxygen atoms derived from polyoxyalkylene) is in a range from 0.8 to 10.

A method for polishing a silicon wafer of the present invention includes a step of polishing a silicon wafer using the polishing composition for a silicon wafer of the present invention.

A method for manufacturing a semiconductor substrate of the present invention includes a step of polishing a silicon wafer using the polishing composition for a silicon wafer of the present invention.

### Effects of the Invention

According to the present invention, it is possible to provide a polishing composition for a silicon wafer, which can reduce both of the surface roughness (haze) and the surface defects (LPD) of a silicon wafer; a method for polishing a silicon wafer using the polishing composition for a silicon wafer; and a method for manufacturing a semiconductor substrate.

### Description of the Invention

The present invention is based on the finding that, when the content of silica particles in a polishing composition for a silicon wafer is 0.01 to 0.50 mass%, adding the following water-soluble polymer to the polishing composition for a silicon wafer (hereinafter also referred to as "polishing composition" simply) makes it possible to reduce both of the surface roughness (haze) and the surface defects (LPD) in a silicon wafer surface (surface to be polished) polished using the polishing composition. Specifically, the water-soluble polymer includes a constitutional unit represented by a general formula (1) below: 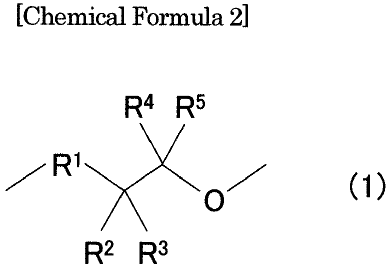 (wherein, in the above general formula (1),
R¹ is a methylene group (-CH₂-) or a bond, and
R², R³, R⁴ and R⁵ each independently represent H (hydrogen atom), -OH (hydroxyl group), -CH₂OH or polyvinyl alcohol, where all of R², R³, R⁴ and R⁵ do not simultaneously represent H (hydrogen atom), -OH (hydroxyl group) or -CH₂OH), and
a ratio of the number of oxygen atoms derived from hydroxyl groups to the number of oxygen atoms derived from polyoxyalkylene (the number of oxygen atoms derived from hydroxyl groups / the number of oxygen atoms derived from polyoxyalkylene) is in a range from 0.8 to 10.

The precise mechanism for producing effects of the present invention, i.e., both of the surface roughness (haze) and the surface defects (LPD) can be reduced in a silicon wafer surface (surface to be polished) polished using the polishing composition of the present invention, is uncertain, the following is presumed.

The water-soluble polymer (component C) included in the polishing composition has an alkyleneoxy group that interacts with a silicon wafer in its main chain in one molecule, and a hydroxyl group that is a site interacting with a silicon wafer in its side chain. Because of this, the water-soluble polymer (component C) adsorbs to the silicon wafer surface, and thus preventing the corrosion of the silicon wafer surface due to the nitrogen-containing basic compound, i.e., an increase of the surface roughness (haze), while exhibiting favorable wettability and thus preventing attachment of particles to the silicon wafer surface, which is considered to result from drying of the silicon wafer surface. Moreover, since wettability of the silicon wafer surface is enhanced when the water-soluble polymer (component C) adsorbs to the silicon wafer surface, uniformity of the polishing of the silicon wafer surface is enhanced and the surface roughness (haze) is reduced.

Further, the water-soluble polymer (component C) does not include water-insoluble matters derived from raw materials as included in HEC. Hence, when the water-soluble polymer (component C) is used in place of HEC, the surface defects (LPD) due to the presence of the water-insoluble matters themselves do not occur.

Thus, it is presumed that the water-soluble polymer (component C) reduces both of the surface roughness (haze) and the surface defects (LPD) of a silicon wafer in the present invention. Note here that the present invention is not limited to this presumption.

### [Silica particles (component A)]

The polishing composition of the present invention includes silica particles as a polishing material. Specific examples of the silica particles include colloidal silica and fumed silica, and colloidal silica is more preferable from the viewpoint of improving the surface smoothness of the silicon wafer.

For the use state of the silica particles, slurry is preferred from the viewpoint of operability. In a case where the polishing material included in the polishing composition of the present invention is colloidal silica, the colloidal silica is preferably obtained from a hydrolyzate of alkoxysilane, from the viewpoint of preventing the silicon wafer from contamination due to an alkali metal, an alkaline earth metal or the like. Silica particles obtained from a hydrolyzate of alkoxysilane can be produced by any conventionally known method.

The average primary particle diameter of the silica particles included in the polishing composition of the present invention is preferably 5 nm or more, more preferably 10 nm or more, further preferably 15 nm or more, and still further preferably 30 nm or more, from the viewpoint of ensuring a polishing speed. Further, the average primary particle diameter of the silica particles is preferably 50 nm or less, more preferably 45 nm or less, and further preferably 40 nm or less, from the viewpoint of ensuring the polishing speed and reducing both of the surface roughness (haze) and the surface defects (LPD) of the silicon wafer.

In particular, in a case of using colloidal silica as the silica particles, the average primary particle diameter is preferably 5 nm or more, more preferably 10 nm or more, further preferably 15 nm or more, and still further preferably 30 nm or more, from the viewpoint of ensuring the polishing speed. Further, the average primary particle diameter of colloidal silica is preferably 50 nm or less, more preferably 45 nm or less, and further preferably 40 nm or less, from the viewpoint of ensuring the polishing speed and reducing both of the surface roughness (haze) and the surface defects (LPD) of the silicon wafer.

The average primary particle diameter of the silica particles is determined using a specific surface area S (m²/g) that is calculated by a BET (nitrogen adsorption) method. The specific surface area can be measured for example by the method described in Examples.

The degree of association of the silica particles is preferably 3.0 or less, more preferably 1.1 to 3.0, further preferably 1.8 to 2.5, and still further preferably 2.0 to 2.3, from the viewpoint of ensuring the polishing speed and reducing both of the surface roughness (haze) and the surface defects (LPD) of the silicon wafer. It is preferred that the shape of the silica particles be a so-called sphere and a so-called cocoon shape. In a case where the silica particles are colloidal silica, the degree of association is preferably 3.0 or less, more preferably 1.1 to 3.0, further preferably 1.8 to 2.5, and still further preferably 2.0 to 2.3, from the viewpoint of ensuring the polishing speed and reducing both of the surface roughness (haze) and the surface defects (LPD) of the silicon wafer.

The degree of association of the silica particles is a coefficient indicating the shape of the silica particles, and it is calculated by the equation below. The average secondary particle diameter is a value measured by dynamic light scattering, and it can be measured for example by using the device described in Examples. Degree of association = average secondary particle diameter / average primary particle diameter

Although there is no particular limitation on the method for adjusting the degree of association of the silica particles, for example, the methods described in JP 1994 (H06)-254383 A, JP 1999(H11)-214338 A, JP 1999(H11)-60232A, JP 2005-060217 A, JP 2005-060219 A and the like can be employed.

The content of the silica particles included in the polishing composition of the present invention in terms of SiO₂ is 0.01 mass% or more, preferably 0.07 mass% or more, and more preferably 0.10 mass% or more, from the viewpoint of ensuring the polishing speed of the silicon wafer. Further, the content of the silica particles included in the polishing composition of the present invention is 0.50 mass% or less, preferably 0.30 mass% or less, and more preferably 0.20 mass% or less, from the viewpoint of reducing both of the surface roughness (haze) and the surface defects (LPD) of the silicon wafer.

### [Nitrogen-containing basic compound (component B)]

The polishing composition of the present invention contains a water-soluble basic compound, from the viewpoint of improving the storage stability of the polishing composition, ensuring the polishing speed, and reducing both of the surface roughness (haze) and the surface defects (LPD) of the silicon wafer. The water-soluble basic compound is at least one kind of nitrogen-containing basic compound selected from an amine compound and an ammonium compound. Here, "water-soluble" indicates having a solubility of 2 g/100 ml or higher with respect to water, and "water-soluble basic compound" indicates a compound exhibiting basicity when being dissolved in water.

Examples of at least one kind of nitrogen-containing basic compound selected from an amine compound and an ammonium compound include: ammonia, ammonium hydroxide, ammonium carbonate, ammonium bicarbonate, methylamine, dimethylamine, trimethylamine, ethylamine, diethylamine, triethylamine, monoethanolamine, diethanolamine, triethanolamine, N-methylethanolamine, N-methyl-N,N-diethanolamine, N,N-dimethylethanolamine, N,N-diethylethanolamine, N,N-dibutylethanolamine, N-(β-aminoethyl)ethanolamine, monoisopropanolamine, diisopropanolamine, triisopropanolamine, ethylenediamine, hexamethylenediamine, piperazine hexahydrate, anhydrous piperazine, 1-(2-aminoethyl)piperazine, N-methylpiperazine, diethylenetriamine, and tetramethyl ammonium hydroxide. Two or more of the kinds of these nitrogen-containing basic compounds may be mixed in use. For the nitrogen-containing basic compound that can be included in the polishing composition of the present invention, ammonia is more preferable from the viewpoint of reducing both of the surface roughness (haze) and the surface defects (LPD) of the silicon wafer, improving the storage stability of the polishing composition, and ensuring the polishing speed.

The content of the nitrogen-containing basic compound included in the polishing composition of the present invention is preferably 0.001 mass% or more, more preferably 0.005 mass% or more, further preferably 0.007 mass% or more, still further preferably 0.010 mass% or more, and still further preferably 0.012 mass% or more, from the viewpoint of reducing both of the surface roughness (haze) and the surface defects (LPD) of the silicon wafer, improving the storage stability of the polishing composition, and ensuring the polishing speed. Further, the content of the nitrogen-containing basic compound is preferably 0.1 mass% or less, more preferably 0.05 mass% or less, further preferably 0.025 mass% or less, still further preferably 0.018 mass% or less, and still further preferably 0.014 mass% or less, from the viewpoint of reducing both of the surface roughness (haze) and the surface defects (LPD) of the silicon wafer.

### [Water-soluble polymer (component C)]

The polishing composition of the present invention includes a water-soluble polymer (component C) including a constitutional unit represented by the general formula (1) below, from the viewpoint of reducing both of the surface roughness (haze) and the surface defects (LPD) of the silicon wafer: 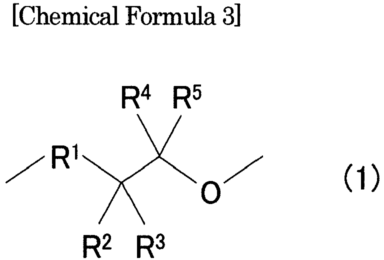 wherein, in the above general formula (1),
R¹ is a methylene group (-CH₂-) or a bond, and
R², R³, R⁴ and R⁵ each independently represent H (hydrogen atom), -OH (hydroxyl group), -CH₂OH or polyvinyl alcohol, where all of R², R³, R⁴ and R⁵ do not simultaneously represent H (hydrogen atom), -OH (hydroxyl group) or -CH₂OH. Here, "water-soluble" indicates having a solubility of 2 g/100 ml or higher with respect to water.

In the water-soluble polymer (component C), the ratio of the number of oxygen atoms derived from hydroxyl groups to the number of oxygen atoms derived from polyoxyalkylene (the number of oxygen atoms derived from hydroxy groups / the number of oxygen atoms derived from polyoxyalkylene) is 0.8 or more from the viewpoint of reducing both of the surface roughness (haze) and the surface defects (LPD) of the silicon wafer, preferably 1.2 or more, more preferably 1.5 or more, and further preferably 1.8 or more. Further, the ratio (the number of oxygen atoms derived from hydroxyl groups / the number of oxygen atoms derived from polyoxyalkylene) is 10 or less from the viewpoint of simplifying the synthesis of the water-soluble polymer, preferably 8.0 or less, more preferably 7.0 or less, and further preferably 6.0 or less.

In the above general formula (1), R², R³, R⁴ and R⁵ each independently represent H (hydrogen atom), -OH (hydroxyl group), -CH₂OH or polyvinyl alcohol, from the viewpoint of reducing the surface roughness and the surface defects of the silicon wafer. It is preferred that three of R², R³, R⁴ and R⁵ be H (hydrogen atom) and the other one be -OH (hydroxyl group) or -CH₂OH, or at least one of R², R³, R⁴ and R⁵ be polyvinyl alcohol and the others be H (hydrogen atom).

From the viewpoint of reducing both of the surface roughness (haze) and the surface defects (LPD) of the silicon wafer, the water-soluble polymer (component C) preferably includes at least one kind of constitutional unit selected from a constitutional unit I represented by a formula (2) below, a constitutional unit II represented by a formula (3) below, and a constitutional unit III represented by the general formula (1) below, wherein R¹ is a bond, and R², R³, R⁴ and R⁵ each independently represent H (hydrogen atom) or polyvinyl alcohol, where all of R², R³, R⁴ and R⁵ do not simultaneously represent H (hydrogen atom), -OH (hydroxyl group) or -CH₂OH, more preferably includes the constitutional unit I, the constitutional unit II or the constitutional unit III, and preferably is at least one kind selected from the group consisting of polyglycidol, a polyglycidol derivative, polyglycerin, a polyglycerin derivative, and a polyvinyl alcohol-polyethylene glycol graft copolymer having polyvinyl alcohol as a side chain.

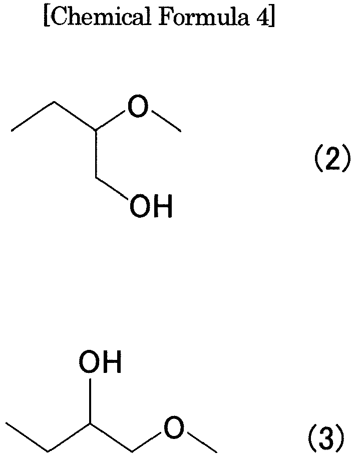

Examples of the polyglycidol derivative include poly(1-methylglycidol), poly(1-ethylglycidol), poly(1-propylglycidol), poly(1-dimethylglycidol), poly(1-diethylglycidol), poly(1-dipropylglycidol), and poly(3-phenylglycidol). Examples of the polyglycerin derivative include polyglycerin stearate, polyglycerin laurate, polyglycerin olate, polyglycerin cuprate, carboxylic acid adduct polyglycerin, amidated polyglycerin, succinylated polyglycerin, and carbamoylated polyglycerin.

The ratio (the number of oxygen atoms derived from hydroxyl groups / the number of oxygen atoms derived from polyoxyalkylene) in the polyvinyl alcohol-polyethylene glycol graft copolymer having polyvinyl alcohol as a side chain and polyethylene glycol as a main chain determined based on the result of analysis by NMR is preferably 0.8 or more, more preferably 1.2 or more, further preferably 1.5 or more, and still further preferably 1.8 or more, from the viewpoint of reducing both of the surface roughness (haze) and the surface defects (LPD) of the silicon wafer.

Further, the ratio (the number of oxygen atoms derived from hydroxyl groups / the number of oxygen atoms derived from polyoxyalkylene) is preferably 10 or less, more preferably 8.0 or less, further preferably 7.0 or less, and still further preferably 6.0 or less, from the viewpoint of simplifying the synthesis of the graft copolymer.

The polyvinyl alcohol-polyethylene glycol graft copolymer includes the constitutional unit III and a constitutional unit IV derived from ethylene glycol. The sequence of these constitutional units may be a block type or a random type.

From the viewpoint of reducing both of the surface roughness (haze) and the surface defects (LPD) of the silicon wafer, the preferable weight average molecular weight of the water-soluble polymer (component C) varies depending on the kind of the water-soluble polymer as described below.

When the water-soluble polymer (component C) is polyglycidol or a polyglycidol derivative, the weight average molecular weight of the water-soluble polymer (component C) is preferably 3,000 or more, more preferably 10,000 or more, further preferably 20,000 or more, and still further preferably 30,000 or more from the viewpoint of reducing both of the surface roughness (haze) and the surface defects (LPD) of the silicon wafer, and preferably 150,000 or less, more preferably 120,000 or less, further preferably 100,000 or less, and still further preferably 80,000 or less from the viewpoint of improving the polishing speed.

When the water-soluble polymer (component C) is polyglycerin or a polyglycerin derivative, the weight average molecular weight of the water-soluble polymer (component C) is preferably 500 or more, more preferably 1,000 or more, further preferably 1,500 or more, and still further preferably 2,000 or more from the viewpoint of reducing both of the surface roughness (haze) and the surface defects (LPD) of the silicon wafer, and preferably 50,000 or less, more preferably 40,000 or less, further preferably 30,000 or less, still further preferably 20,000 or less, still further preferably 10,000 or less, and still further preferably 5,000 or less from the viewpoint of improving the polishing speed.

When the water-soluble polymer (component C) is the polyvinyl alcohol-polyethylene glycol graft copolymer, the weight average molecular weight of the water-soluble polymer (component C) is preferably 10,000 or more, more preferably 12,000 or more, further preferably 15,000 or more, and still further preferably 30,000 or more from the viewpoint of reducing both of the surface roughness (haze) and the surface defects (LPD) of the silicon wafer, and preferably 400,000 or less, more preferably 300,000 or less, further preferably 150,000 or less, still further preferably 120,000 or less, still further preferably 100,000 or less, and still further preferably 80,000 or less from the viewpoint of improving the polishing speed.

The content of the water-soluble polymer (component C) included in the polishing composition of the present invention is preferably 0.001 mass% or more, more preferably 0.002 mass% or more, further preferably 0.004 mass% or more, and still further preferably 0.007 mass% or more, from the viewpoint of reducing both of the surface roughness (haze) and the surface defects (LPD) of the silicon wafer. Further, the content of the water-soluble polymer (component C) included in the polishing composition of the present invention is preferably 0.1 mass% or less, more preferably 0.05 mass% or less, further preferably 0.035 mass% or less, and still further preferably 0.030 mass% or less, from the viewpoint of reducing both of the surface roughness (haze) and the surface defects (LPD) of the silicon wafer.

The ratio of the content of the silica particles (component A) to the content of the water-soluble polymer (component C) (mass% of the component A / mass% of the component C) included in the polishing composition of the present invention is preferably 1 or more, more preferably 3 or more, and further preferably 5 or more, from the viewpoint of improving the polishing speed. Further, the ratio (mass% of the component A / mass% of the component C) is preferably 38 or less, more preferably 30 or less, further preferably 25 or less, and still further preferably 20 or less, from the viewpoint of reducing both of the surface roughness (haze) and the surface defects (LPD) of the silicon wafer.

### [Aqueous medium (component D)]

Examples of an aqueous medium (component D) included in the polishing composition of the present invention include water such as ion-exchanged water and ultrapure water, and a mixed medium of water and a solvent. For the solvent, a solvent mixable with water (e.g., alcohols such as ethanol) is preferred. Among them, for the aqueous medium, ion-exchanged water or ultrapure water is more preferred, and ultrapure water is further preferred. In a case where the aqueous medium (component D) is a mixed medium of water and a solvent, the percentage of water with respect to the whole mixed medium as the component D is not limited particularly, but it is preferably 95 mass% or more, more preferably 98 mass% or more, and further preferably substantially 100 mass% from the economical viewpoint.

The content of the aqueous medium in the polishing composition of the present invention is not limited particularly, and it may be the remainder of the components A-C and an optional component described below.

The pH of the polishing composition of the present invention at 25°C is preferably 8.0 or more, more preferably 9.0 or more, further preferably 9.5 or more, and preferably 12.0 or less, more preferably 11.5 or less, and further preferably 11.0 or less, from the viewpoint of ensuring the polishing speed. The pH can be adjusted by appropriately adding the nitrogen-containing basic compound (component B) and/or a pH regulator as needed. Here, the pH at 25°C can be measured using a pH meter (HM-30G, DKK-TOA CORPORATION) and is read on the pH meter 1 minute after dipping an electrode into the polishing composition.

### [Optional component (assistant)]

The polishing composition of the present invention may further include at least one kind of optional component selected from a water-soluble polymer compound (component E) other than the water-soluble polymer compound (component C), a pH regulator, an anticorrosion agent, alcohols, a chelating agent, an anionic surfactant, and a nonionic surfactant, as long as the effects of the present invention are not impaired.

### [Water-soluble polymer compound (component E)]

The polishing composition of the present invention may further contain a water-soluble polymer compound (component E) other than the water-soluble polymer compound (component C), from the viewpoint of reducing both of the surface roughness (haze) and the surface defects (LPD) of the silicon wafer. The water-soluble polymer compound (component E) is a polymer compound having a hydrophilic group, and the weight average molecular weight of the water-soluble polymer compound (component E) is preferably 10,000 or more, and more preferably 100,000 or more, from the viewpoint of ensuring the polishing speed and reducing the surface defects of the silicon wafer. Examples of the monomer as a supply source constituting the component E include monomers having a water-soluble group such as an amide group, a hydroxyl group, a carboxyl group, a carboxylic acid ester group, and a sulfonic acid group. Examples of the water-soluble polymer compound (component E) include polyamide, poly(N-acylalkyleneimine), a cellulose derivative, polyvinyl alcohol, and polyethylene oxide. Examples of the polyamide include polyvinyl pyrrolidone, polyacrylamide, polyoxazoline, polydimethylacrylamide, polydiethylacrylamide, polyisopropylacrylamide, and polyhydroxyethylacrylamide. Examples of the poly(N-acylalkyleneimine) include poly(N-acetylethyleneimine), poly(N-propionylethyleneimine), poly(N-caproylethyleneimine), poly(N-benzoylethyleneimine), poly(N-nonadezoylethyleneimine), poly(N-acetylpropyleneimine), and poly(N-butionylethyleneimine). Examples of the cellulose derivatives include carboxymethyl cellulose, hydroxyethyl cellulose, hydroxyethyl methyl cellulose, hydroxypropyl cellulose, hydroxypropyl methyl cellulose, methyl cellulose, ethyl cellulose, hydroxyethyl ethyl cellulose, and carboxymethyl ethyl cellulose. Two or more kinds of these water-soluble polymer compounds may be mixed in use at a certain ratio.

### [pH regulator]

The pH regulator may be, e.g., an acid compound. Examples of the acid compound include inorganic acids such as sulfuric acid, hydrochloric acid, nitric acid, and phosphoric acid and organic acids such as acetic acid, oxalic acid, succinic acid, glycolic acid, malic acid, citric acid, and benzoic acid.

### [Anticorrosion agent]

Examples of the anticorrosion agent include benzalkonium chloride, benzethonium chloride, 1,2-benzisothiazolin-3-one, (5-chloro-)2-methyl-4-isothiazoline-3-one, hydrogen peroxide, and hypochlorite.

### [Alcohols]

Examples of the alcohols include methanol, ethanol, propanol, butanol, isopropyl alcohol, 2-methyl-2-propanol, ethylene glycol, propylene glycol, polyethylene glycol, and glycerin. The content of the alcohols in the polishing composition of the present invention is preferably 0.1 to 5 mass%.

### [Chelating agent]

Examples of the chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, triethylenetetraminehexaacetic acid, and sodium triethylenetetraminehexaacetic acid. The content of the chelating agent in the polishing composition of the present invention is preferably 0.01 to 1 mass%.

### [Anionic surfactant]

Examples of the anionic surfactant include fatty acid soap, carboxylates such as alkyl ether carboxylate, sulfonates such as alkyl benzene sulfonate and alkyl naphthalene sulfonate, sulfates such as fatty alcohol sulfate and alkyl ether sulfate, and phosphates such as alkyl phosphate.

### [Nonionic surfactant]

Examples of the nonionic surfactant include: polyethylene glycol types such as polyoxyethylene sorbitan fatty acid ester, polyoxyethylene sorbitol fatty acid ester, polyoxyethylene glycerin fatty acid ester, polyoxyethylene fatty acid ester, polyoxyethylene alkylether, polyoxyethylene alkyl phenyl ether, and polyoxyalkylene (hydrogenated) castor oil; polyhydric alcohol types such as sucrose fatty acid ester and alkyl glycoside; and fatty acid alkanolamide.

The content of each of the components described above is the amount when the polishing composition is being used. However, the polishing composition of the present invention may be stored and supplied in a concentrated state as long as the storage stability is not impaired. This is preferred because the production and transportation costs can be reduced further. The concentrated liquid may be appropriately diluted with the above-mentioned aqueous medium as needed. The concentration rate is not limited particularly as long as the concentration of the diluted solution can be ensured during the polishing. The concentration rate is preferably 2 times or more, more preferably 10 times or more, further preferably 20 times or more, still further preferably 30 times or more, and preferably 100 times or less, more preferably 80 times or less, further preferably 60 times or less, and still further preferably 50 times or less, from the viewpoint of further reducing the production and transportation costs.

In a case where the polishing composition of the present invention is the above-mentioned concentrated liquid, the content of the silica particles (component A) in the concentrated liquid in terms of SiO₂ is preferably 2 mass% or more, more preferably 4 mass% or more, and further preferably 6 mass% or more, from the viewpoint of reducing the production and transportation costs. Further, the content of the silica particles in the concentrated liquid is preferably 40 mass% or less, more preferably 35 mass% or less, further preferably 20 mass% or less, still further preferably 15 mass% or less, and still further preferably 9 mass% or less, from the viewpoint of improving the storage stability.

In a case where the polishing composition of the present invention is the above-mentioned concentrated liquid, the content of the nitrogen-containing basic compound (component B) in the concentrated liquid is preferably 0.02 mass% or more, more preferably 0.05 mass% or more, and further preferably 0.1 mass% or more, from the viewpoint of reducing the production and transportation costs. Further, the content of the nitrogen-containing basic compound (component B) in the concentrated liquid is preferably 5 mass% or less, more preferably 2 mass% or less, and further preferably 1 mass% or less, from the viewpoint of improving the storage stability.

In a case where the polishing composition of the present invention is the above-mentioned concentrated liquid, the content of the water-soluble polymer compound (component C) in the concentrated liquid is preferably 0.005 mass% or more, more preferably 0.01 mass% or more, further preferably 0.02 mass% or more, still further preferably 0.05 mass% or more, and still further preferably 0.1 mass% or more, from the viewpoint of reducing the production and transportation costs. Further, the content of the water-soluble polymer compound (component C) in the concentrated liquid is preferably 5 mass% or less, more preferably 3 mass% or less, further preferably 2 mass% or less, and still further preferably 1.5 mass% or less, from the viewpoint of improving the storage stability.

In a case where the polishing composition of the present invention is the above-mentioned concentrated liquid, the pH of the concentrated liquid at 25°C is preferably 8.0 or more, more preferably 9.0 or more, further preferably 9.5 or more, and preferably 12.0 or less, more preferably 11.5 or less, and further preferably 11.0 or less.

Hereinafter, one example of the method for producing the polishing composition of the present invention will be described.

There is no limitation on the example of the method for producing the polishing composition of the present invention. For example, the composition can be prepared by mixing the silica particles (component A), the nitrogen-containing basic compound (component B), the water-soluble polymer compound (component C), the aqueous medium (component D), and the optional component as needed.

The silica particles can be dispersed in the aqueous medium using any stirrer such as a homomixer, a homogenizer, an ultrasonic disperser, a wet ball mill, or a bead mill. If coarse particles resulting from the aggregation or the like of the silica particles are included in the aqueous medium, it is preferred that the coarse particles be removed by centrifugation, filtration with a filter, etc. The silica particles are dispersed in the aqueous medium preferably in the presence of the water-soluble polymer compound (component C). Specifically, preferably, after preparation of an additive composition for silicon wafer polishing including the water-soluble polymer compound (component C) and the aqueous medium (component D), the additive composition for silicon wafer polishing and silica particles are mixed, and thereafter the obtained mixture of the additive composition for silicon wafer polishing and silica particles are diluted with the aqueous medium (component D) as needed.

The polishing composition of the present invention is used for example in a step of polishing a silicon wafer in the process of manufacturing a semiconductor substrate, or a method for polishing a silicon wafer including a step of polishing a silicon wafer.

The step of polishing a silicon wafer includes a lapping (rough polishing) step and a final polishing step. The lapping step includes planarizing the silicon wafer that has been obtained by slicing a silicon single crystal ingot into thin disks. The final polishing step includes etching the lapped silicon wafer and then mirror-finishing the surfaces of the silicon wafer. It is more preferred that the polishing composition of the present invention be used in the final polishing step.

In the method for manufacturing the semiconductor substrate or the method for polishing a silicon wafer, a dilution step of diluting the polishing composition (concentrated liquid) of the present invention may be included in advance of the step of polishing a silicon wafer. For the dilution medium, the aqueous medium (component D) may be used.

From the viewpoint of reducing the production and transportation costs and improving the storage stability, the concentrated liquid to be diluted in the dilution step preferably include the component A in the range of 2 to 40 mass%, the component B in the range of 0.02 to 5 mass%, and the component C in the range of 0.005 to 5 mass%, for example.

The present invention further discloses the following <1> to <15>.
<1> A polishing composition for a silicon wafer, including:
   0.01 to 0.5 mass% of silica particles;
   a nitrogen-containing basic compound; and
   a water-soluble polymer,
   wherein the water-soluble polymer includes a constitutional unit represented by a general formula (1) below: 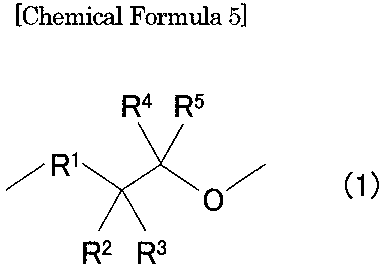 (wherein, in the above general formula (1),
   R¹ is a methylene group (-CH₂-) or a bond, and
   R², R³, R⁴ and R⁵ each independently represent H (hydrogen atom), -OH (hydroxyl group), -CH₂OH or polyvinyl alcohol, where all of R², R³, R⁴ and R⁵ do not simultaneously represent H (hydrogen atom), -OH (hydroxyl group) or -CH₂OH), and
   in the water-soluble polymer, a ratio of the number of oxygen atoms derived from hydroxyl groups to the number of oxygen atoms derived from polyoxyalkylene (the number of oxygen atoms derived from hydroxyl groups / the number of oxygen atoms derived from polyoxyalkylene) is in a range from 0.8 to 10.
<2> The polishing composition for a silicon wafer according to <1>, wherein the water-soluble polymer is a polyvinyl alcohol-polyethylene glycol graft copolymer.
<3> The polishing composition for a silicon wafer according to <1> or <2>, wherein the water-soluble polymer is a polyvinyl alcohol-polyethylene glycol graft copolymer having polyvinyl alcohol as a side chain and polyethylene glycol as a main chain.
<4> The polishing composition for a silicon wafer according to <2> or <3>, wherein a weight average molecular weight of the polyvinyl alcohol-polyethylene glycol graft copolymer is preferably 10,000 or more, more preferably 12,000 or more, further preferably 15,000 or more, still further preferably 30,000 or more, and preferably 400,000 or less, more preferably 300,000 or less, further preferably 150,000 or less, still further preferably 120,000 or less, still further preferably 100,000 or less, and still further preferably 80,000 or less.
<5> The polishing composition for a silicon wafer according to <1>, wherein the water-soluble polymer is polyglycidol and/or a polyglycidol derivative.
<6> The polishing composition for a silicon wafer according to <5>, wherein weight average molecular weights of the polyglycidol and polyglycidol derivative are preferably 3,000 or more, more preferably 10,000 or more, further preferably 20,000 or more, still further preferably 30,000 or more, and preferably 150,000 or less, more preferably 120,000 or less, further preferably 100,000 or less, and still further preferably 80,000 or less.
<7> The polishing composition for a silicon wafer according to <1>, wherein the water-soluble polymer is polyglycerin and/or a polyglycerin derivative.
<8> The polishing composition for a silicon wafer according to <7>, wherein weight average molecular weights of the polyglycerin and polyglycerin derivative are preferably 500 or more, more preferably 1,000 or more, further preferably 1,500 or more, still further preferably 2,000 or more, and preferably 50,000 or less, more preferably 40,000 or less, further preferably 30,000 or less, still further preferably 20,000 or less, still further preferably 10,000 or less, and still further preferably 5,000 or less.
<9> The polishing composition for a silicon wafer according to any one of <1> to <8>, wherein a mass ratio of the silica particles to the water-soluble polymer (a mass of the silica particles / a mass of the water-soluble polymer) is preferably 1 or more, more preferably 3 or more, further preferably 5 or more, and preferably 38 or less, more preferably 30 or less, further preferably 25 or less, and still further preferably 20 or less.
<10> The polishing composition for a silicon wafer according to any one of <1> to <9>, wherein the ratio (the number of oxygen atoms derived from hydroxyl groups / the number of oxygen atoms derived from polyoxyalkylene) is 0.8 or more, preferably 1.2 or more, more preferably 1.5 or more, further preferably 1.8 or more, and 10 or less, preferably 8.0 or less, more preferably 7.0 or less, and further preferably 6.0 or less.
<11> The polishing composition for a silicon wafer according to any one of <1> to<10>, wherein a content of the silica particles included in the polishing composition for a silicon wafer in terms of SiO₂ is 0.01 mass% or more, preferably 0.07 mass% or more, more preferably 0.10 mass% or more, and 0.50 mass% or less, preferably 0.30 mass% or less, and more preferably 0.20 mass% or less.
<12> The polishing composition for a silicon wafer according to any one of <1> to <11>, wherein a content of the water-soluble polymer (component C) included in the polishing composition for a silicon wafer is preferably 0.001 mass% or more, more preferably 0.002 mass% or more, further preferably 0.004 mass% or more, still further preferably 0.007 mass% or more, and preferably 0.1 mass% or less, more preferably 0.05 mass% or less, further preferably 0.035 mass% or less, and still further preferably 0.030 mass% or less.
<13> A method for polishing a silicon wafer, including a step of polishing a silicon wafer using the polishing composition for a silicon wafer according to any one of <1> to <12>.
<14> A method for manufacturing a semiconductor substrate, including a step of polishing a silicon wafer using the polishing composition for a silicon wafer according to any one of <1> to <12>.
<15> A use of the polishing composition for a silicon wafer according to any one of <1> to <12> in polishing of a silicon wafer.

### Examples

The following details water-soluble polymers (polymers A) and polymers B of Table 1, which were used in Examples 1-17 and Comparative Examples 1-11 described below.

### (Polymer A No. 1)

0.73 g of Sm (TMHD) 3 (Wako Pure Chemical Industries, Ltd.) was weighed, and 30 ml of nitrogen-substituted dioxane was added thereto, followed by dissolution of the Sm (TMHD) 3 at 60°C. After cooling, 0.44 ml of a MAO toluene solution (Tosoh Finechem Corporation) was dropped onto the obtained solution while stirring, and the mixed solution was stirred further for 15 minutes, whereby a catalyst solution was obtained. Next, 23 ml of glycidol (Wako Pure Chemical Industries, Ltd.) was dissolved in 23 ml of dioxane, and this was added to the catalyst solution and then reacted at 100°C for 3 hours. 10 ml of ethanol was further added to the catalyst solution, and the obtained precipitate was taken by filtration. Next, the precipitate was subjected to soak washing with isopropyl alcohol, and dried under reduced pressure, whereby crude polyglycidol was obtained. 10 g of the obtained crude polyglycidol was dissolved in ion-exchanged water, and 0.1 g of hinokitiol was further added thereto and stirred for 30 minutes at 70°C. The obtained precipitate was separated by filtration, and an aqueous solution obtained by the filtration was washed with hexane and concentrated. Then, it was subjected to soak washing with isopropyl alcohol, dried under reduced pressure, and precipitated again. After drying, the precipitate was dissolved again in a small amount of ion-exchanged water, and then freeze-dried, whereby a transparent and colorless solid (polyglycidol) was obtained.

### (Polymer A No. 2)

Polyglycerin (trade name: Polyglycerin X, weight average molecular weight 3000, manufactured by Daicel Corporation)

### (Polymer A No. 3)

10 g of polyethylene glycol (weight average molecular weight 2000, Wako Pure Chemical Industries, Ltd.) was introduced into a polymerization vessel, and heated to 80°C while being stirred under a gentle nitrogen flow. While keeping the stirring of polyethylene glycol at 80°C, 36 g of vinyl acetate was dropped into the polymerization vessel for 3 hours, and at the same time, a solution obtained by adding 0.14 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:1.8, which was calculated from the result of analysis by NMR, was obtained.

### (Polymer A No. 4)

10 g of polyethylene glycol (weight average molecular weight 1000, Wako Pure Chemical Industries, Ltd.) was introduced into a polymerization vessel, and heated to 80°C while being stirred under a gentle nitrogen flow. While keeping the stirring of polyethylene glycol at 80°C, 60 g of vinyl acetate was dropped into the polymerization vessel for 3 hours, and at the same time, a solution obtained by adding 0.24 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PvA of 1:3 calculated from NMR was obtained.

### (Polymer A No. 5)

10 g of polyethylene glycol (weight average molecular weight 1000, Wako Pure Chemical Industries, Ltd.) was introduced into a polymerization vessel, and heated to 80°C while being stirred under a gentle nitrogen flow. While keeping the stirring of polyethylene glycol at 80°C, 140 g of vinyl acetate was dropped into the polymerization vessel for 3 hours, and at the same time, a solution obtained by adding 0.56 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:7 calculated from NMR was obtained.

### (Polymer A No. 6)

Polyvinyl alcohol-polyethylene glycol graft copolymer (trade name: Kollicoat (registered trademark) IR, weight average molecular weight 26500, manufactured by BASF SE)

### (Polymer A No. 7)

10 g of polyethylene glycol (weight average molecular weight 6000, Wako Pure Chemical Industries, Ltd.) was introduced into a polymerization vessel, and heated to 80°C while being stirred under a gentle nitrogen flow. While keeping the stirring of polyethylene glycol at 80°C, 86 g of vinyl acetate was dropped into the polymerization vessel for 3 hours, and at the same time, a solution obtained by adding 0.34 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:4.3 calculated from NMR was obtained.

### (Polymer A No. 8)

10 g of polyethylene glycol (weight average molecular weight 20000, Wako Pure Chemical Industries, Ltd.) was introduced into a polymerization vessel, and heated to 80°C while being stirred under a gentle nitrogen flow. While keeping the stirring of polyethylene glycol at 80°C, 22 g of vinyl acetate was dropped into the polymerization vessel for 3 hours, and at the same time, a solution obtained by adding 0.09 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:1.1 calculated from NMR was obtained.

### (Polymer A No. 9)

10 g of polyethylene glycol (weight average molecular weight 20000, Wako Pure Chemical Industries, Ltd.) was introduced into a polymerization vessel, and heated to 80°C while being stirred under a gentle nitrogen flow. While keeping the stirring of polyethylene glycol at 80°C, 60 g of vinyl acetate was dropped into the polymerization vessel for 3 hours, and at the same time, a solution obtained by adding 0.24 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:3 calculated from NMR was obtained.

### (Polymer A No. 10)

10 g of polyethylene glycol (weight average molecular weight 20000, Wako Pure Chemical Industries, Ltd.) was introduced into a polymerization vessel, and heated to 80°C while being stirred under a gentle nitrogen flow. While keeping the stirring of polyethylene glycol at 80°C, 80 g of vinyl acetate was dropped into the polymerization vessel for 3 hours, and at the same time, a solution obtained by adding 0.32 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:4 calculated from NMR was obtained.

### (Polymer A No. 11)

10 g of polyethylene glycol (weight average molecular weight 20000, Wako Pure Chemical Industries, Ltd.) was introduced into a polymerization vessel, and heated to 80°C while being stirred under a gentle nitrogen flow. While keeping the stirring of polyethylene glycol at 80°C, 156 g of vinyl acetate was dropped into the polymerization vessel for 3 hours, and at the same time, a solution obtained by adding 0.62 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:7.8 calculated from NMR was obtained.

### (Polymer A No. 12)

10 g of polyethylene glycol (weight average molecular weight 40000, Wako Pure Chemical Industries, Ltd.) was introduced into a polymerization vessel, and heated to 80°C while being stirred under a gentle nitrogen flow. While keeping the stirring of polyethylene glycol at 80°C, 80 g of vinyl acetate was dropped into the polymerization vessel for 3 hours, and at the same time, a solution obtained by adding 0.32 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:4 calculated from NMR was obtained.

### (Polymer A No. 13)

10 g of polyethylene glycol (weight average molecular weight 80000, Meisei Chemical Works, Ltd.) was introduced into a polymerization vessel, and heated to 80°C while being stirred under a gentle nitrogen flow. While keeping the stirring of polyethylene glycol at 80°C, 80 g of vinyl acetate was dropped into the polymerization vessel for 3 hours, and at the same time, a solution obtained by adding 0.32 g of tert-butylperpivalate to 5 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:4 calculated from NMR was obtained.

### (Polymer A No. 14)

20 g of polyethylene glycol (weight average molecular weight 6000, Wako Pure Chemical Industries, Ltd.) was introduced into a polymerization vessel, and heated to 80°C while being stirred under a gentle nitrogen flow. While keeping the stirring of polyethylene glycol at 80°C, 20 g of vinyl acetate was dropped into the polymerization vessel for 3 hours, and at the same time, a solution obtained by adding 0.08 g of tert-butylperpivalate to 1 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:0.5 calculated from NMR was obtained.

### (Polymer A No. 15)

20 g of polyethylene glycol (weight average molecular weight 80000, Meisei Chemical Works, Ltd.) was introduced into a polymerization vessel, and heated to 80°C while being stirred under a gentle nitrogen flow. While keeping the stirring of polyethylene glycol at 80°C, 20 g of vinyl acetate was dropped into the polymerization vessel for 3 hours, and at the same time, a solution obtained by adding 0.08 g of tert-butylperpivalate to 1 g of methanol was dropped into the polymerization vessel for 3 hours as well. After completion of these droppings, the obtained mixture was stirred for 2 hours at 80°C. After cooling, the obtained polymer was dissolved in 100 ml of methanol. To cause hydrolysis, 15 ml of methanolic sodium hydroxide solution at a concentration of 10 mass% was added into the polymerization vessel at 30°C. After a lapse of about 40 minutes, 22.5 ml of acetic acid at a concentration of 10 mass% was added into the polymerization vessel to stop the reaction. The obtained solution was distilled under reduced pressure, and methanol was removed from the solution. Next, the obtained solution was dialyzed (Visking tube, molecular weight cut off 12,000-14,000, Nihon Medical Science, Inc.) for 3 days, and then freeze-dried. Thus, colorless powdery polyvinyl alcohol-polyethylene glycol graft copolymer having a polymerization ratio of PEG to PVA of 1:0.5 calculated from NMR was obtained.

### (Polymer A No. 16)

Hydroxyethyl cellulose (trade name CF-V, weight average molecular weight 800,000, Sumitomo Seika Chemicals Co., Ltd)

### (Polymer A No. 17)

Hydroxyethyl cellulose (trade name SE400, weight average molecular weight 250,000, Daicel Corporation)

### (Polymer A No. 18, Polymer B)

Polyethylene glycol (weight average molecular weight 6,000, Wako Pure Chemical Industries, Ltd.)

### (Polymer A No. 19)

Polyvinyl alcohol (trade name PVA105, weight average molecular weight 43,000, Kuraray Co., Ltd.)

The polymer A No. 1 is polyglycidol, wherein, in the general formula (1), R¹ is a bond, R², R³ and R⁴ are H (hydrogen atom), and R⁵ is -CH₂OH.

The polymer A No. 2 is polyglycerin, wherein, in the general formula (1), R¹ is a methylene group (-CH₂-), R² is -OH (hydroxyl group), R³, R⁴ and R⁵ are H (hydrogen atom).

The polymers A Nos. 3-15 are polyvinyl alcohol-polyethylene glycol graft copolymers having polyethylene glycol as a main chain and polyvinyl alcohol as a side chain. The polymers A Nos. 3-15 include a constitutional unit III, wherein in the above general formula (1), R¹ is a bond, and R², R³, R⁴ and R⁵ each independently represent H (hydrogen atom) or polyvinyl alcohol, where R², R³, R⁴ and R⁵ do not simultaneously represent a hydrogen atom, and also include a constitutional unit IV derived from ethylene glycol.

### < Solubility of polymerA>

All of the polymers A Nos. 1-19 had a solubility of 2 g/100 ml or higher with respect to water at 20°C.

### <Measurement of weight average molecular weight>

The weight average molecular weight of each of the polymers A Nos. 1-19 was calculated with reference to the peak in chromatogram obtained by applying a gel permeation chromatography (GPC) method under the conditions below.
Instrument: HLC-8320 GPC (Tosoh Corporation, detector integral type)
Column: GMPWXL+GMPWXL (anion)
Eluant: 0.2M phosphoric acid buffer / CH₃CN = 9/1
Flow rate: 0.5 ml/min
Column temperature: 40°C
Detector: RI detector
Reference material: polyethylene glycol

### <Ratio (the number of oxygen atoms derived from hydroxyl groups / the number of oxygen atoms derived from polyoxyalkylene)>

When the polymer A was a polyvinyl alcohol-polyethylene glycol graft copolymer, the ratio (the number of oxygen atoms derived from hydroxyl groups / the number of oxygen atoms derived from polyoxyalkylene) was calculated by 1H-NMR. Specifically, the number of oxygen atoms derived from polyoxyalkylene was calculated from the integration ratio of ethylene in an alkyleneoxide moiety of the polymer main chain, and the number of oxygen atoms derived from hydroxyl groups was calculated from the integration ratio of ethylene in a polyvinyl alcohol moiety of the side chain. The ratio (the number of oxygen atoms derived from hydroxyl groups / the number of oxygen atoms derived from polyoxyalkylene) was calculated using these values. When the polymer A was polyglycidol or polyglycerin, the ratio (the number of oxygen atoms derived from hydroxyl groups / the number of oxygen atoms derived from polyoxyalkylene) became almost 1 because of its structure.

### <Average primary particle diameter of polishing material (silica particles)>

The average primary particle diameter (nm) of the polishing material was calculated by the equation below using a specific surface area S (m²/g) calculated by the BET (nitrogen adsorption) method.
Average primary particle diameter (nm) = 2727/S

The specific surface area of the polishing material was determined in the following manner. After the following "pre-treatment" was performed, a measurement sample of about 0.1 g was accurately weighed in a measuring cell to four decimal places. The measurement sample was dried in an atmosphere at 110°C for 30 minutes immediately before measuring the specific surface area. Then, the specific surface area was measured by the nitrogen adsorption (BET) method using a specific surface area measuring device (Micromeritics Automatic Surface Area Analyzer, FlowSorb III 2305 manufactured by Shimadzu Corporation).

### [Pre-treatment]

(a) The polishing material in the form of slurry was adjusted to pH 2.5 ± 0.1 with a nitric acid aqueous solution.
(b) The polishing material in the form of slurry having an adjusted pH of 2.5 ± 0.1 was put in a petri dish and dried in a hot air dryer at 150°C for 1 hour.
(c) After drying, the resultant sample was pulverized in an agate mortar.
(d) The pulverized sample was suspended in ion-exchanged water at 40°C, and this suspension was filtered through a membrane filter with a pore size of 1 µm.
(e) The substances deposited on the filter were washed five times with 20 g of ion-exchanged water (40°C).
(f) The filter to which the substances were attached was put in a petri dish and dried in an atmosphere at 110°C for 4 hours.
(g) The dried substances (abrasive grains) were taken out so as not to be mixed with filter scraps and pulverized in a mortar, thereby providing a measurement sample.

### <Average secondary particle diameter of polishing material (silica particles)>

The average secondary particle diameter (nm) of the polishing material was determined in the following manner. The polishing material was added to ion-exchanged water so that the concentration of the polishing material would be 0.25 mass%. The resultant aqueous solution was poured into a disposable sizing cuvette (made of polystyrene, 10 mm cell) to a height of 10 mm from the bottom, and then was measured by dynamic light scattering (device name: Zetasizer Nano ZS, manufactured by Sysmex Corporation).

### (1) Preparation of polishing composition

Silica particles (colloidal silica, average primary particle diameter: 35 nm, average secondary particle diameter: 70 nm, degree of association: 2), the water-soluble polymer (polymer A), 28 mass% ammonia water (special grade reagent manufactured by Kishida Chemical Co., Ltd.), ion-exchanged water, and as needed the polymer B were stirred and mixed so as to obtain the polishing compositions of Examples 1-17 and Comparative Examples 1-11 (all were concentrated liquids with pH of 10.6 ± 0.1 (25°C)). A remainder after subtracting the silica particles, the water-soluble polymer (polymer A), the ammonia, and the polymer B is ion-exchanged water. The contents of the respective components shown in Table 1 are values regarding the polishing compositions obtained by diluting the concentrated liquids by 40 times, and the content of the silica particles is the concentration of the silica particles in terms of SiO₂.

### (2) Polishing method

A polishing composition (concentrated liquid) was diluted by 40 times with ion-exchanged water. The resultant polishing composition (pH 10.6 ± 0.1 (25°C)) was filtered with a filter (compact cartridge filter MCP-LX-C10S, Advantec Co., Ltd.) immediately before polishing, and silicon wafers described below (silicon single-sided mirror wafer 200 mm in diameter (conduction type: P, crystal orientation: 100, resistivity: 0.1 Ω•cm or more and less than 100 Ω•cm)) were subjected to a final polishing under the polishing conditions as described below. In advance of the final polishing, the silicon wafers each was roughly polished by use of a commercially available polishing composition. The silicon wafer that has been roughly polished before a final polishing had a surface roughness (haze) of 2.680 ppm. For the surface roughness (haze), the value at the dark field wide oblique incidence channel (DWO) measured using Surfscan SP1-DLS (trade name) manufactured by KLA-Tencor Corporation was used.

### <Conditions for final polishing>

Polishing machine: a single-sided 8-inches polishing machine GRIND-X SPP600s (manufactured by Okamoto Machine Tool Works, Ltd.)
Polishing pad: suede pad (manufactured by Toray Coatex Co., Ltd., ASKER hardness: 64, thickness:1.37 mm, nap length: 450 µm, opening diameter: 60 µm)
Silicon wafer polishing pressure: 100 g/cm²
Plate rotation speed: 60 rpm
Time of polishing: 5 minutes
Polishing composition supply rate:150 g/cm²
Temperature of polishing composition: 23°C
Carrier rotation speed: 60 rpm

After the final polishing, the silicon wafer was subjected to washing with ozone and washing with dilute hydrofluoric acid as described below. In the washing with ozone, an aqueous solution including 20 ppm of ozone was jetted at a flow speed of 1 L/min. for 3 minutes from a nozzle toward the center of a silicon wafer rotating at 600 rpm. At this time, the temperature of the ozone water was set to a room temperature. Next, washing with dilute hydrofluoric acid was performed. In the washing with dilute hydrofluoric acid, an aqueous solution including 0.5 mass% ammonium hydrogen fluoride (special class; Nacalai Tesque, Inc.) was jetted at a flow speed of 1 L/min. for 6 seconds from a nozzle toward the center of the silicon wafer rotating at 600 rpm. The set of one washing with ozone and one washing with dilute hydrofluoric acid was performed twice, which was followed by a final spin drying. In the spin drying, the silicon wafer was rotated at 1500 rpm.

### <Evaluation of surface roughness (haze) and surface defects (LPD) of silicon wafer>

For the evaluation of the surface roughness (haze)(ppm) of the washed silicon wafer surface, the values at the dark field wide oblique incidence channel (DWO) measured using Surfscan SP1-DLS (trade name) manufactured by KLA-Tencor Corporation were used. The surface defects (LPD) (the number of defects) were measured simultaneously with the haze measurement, and evaluated by measuring the number of particles having a diameter of 45 nm or more present on the silicon wafer surface. A smaller haze value indicates a higher surface flatness. A smaller number of LPD (the number of particles) indicates less surface defects. Table 1 shows the results of the surface roughness (haze) and the surface defects (LPD). For the surface roughness (haze) and surface defect (LPD) measurements, two each of silicon wafers were used, and the average values thereof are shown in Table 1.

### <Evaluation of wettability>

The area of a hydrophilic portion (wet portion) on the mirror surface of a silicon wafer (diameter 200 mm) immediately after final polishing was observed visually, and the wettability was evaluated in accordance with the following evaluation criteria. Table 1 shows the results.

### (Evaluation criteria)

A: The percentage of the area of the wet portion was 95% or more.
B: The percentage of the area of the wet portion was 90% or more and less than 95%.
C: The percentage of the area of the wet portion was 50% or more and less than 90%.
D: The percentage of the area of the wet portion was less than 50%.

### <Evaluation of dispersed particle diameter>

The dispersed particle diameter of the silica particles in the polishing composition was measured using a polishing composition (pH 10.6 ± 0.1 (25°C)) obtained by diluting a polishing composition (concentrated liquid) with ion-exchanged water by 40 times. As a particle size analyzer used for the dispersed particle diameter measurement, "Zetasizer Nano ZS" operating based on the principle of photon correlation (dynamic light scattering) manufactured by Sysmex Corporation was used. 1.2 mL of the polishing composition as a measuring liquid was collected in a disposable sizing cuvette (made of polystyrene, 10 mm cell), and placed in the measurement part. A volume median particle diameter (D50) was measured as a dispersed particle diameter. Table 1 below shows the results. A smaller D50 value indicates better dispersibility of the silica particles.

### < Evaluation of amount of corrosion >

A silicon wafer cut into 40 × 40 mm square was immersed in a 1 mass% diluted hydrofluoric acid aqueous solution for 2 minutes to remove the oxide film, and subsequently the silicon wafer was immersed in ion-exchanged water for an instant, rinsed, and dried by air blow. Next, the silicon wafer was placed in a plastic container, and then 20 g of the polishing composition was added to the plastic container and covered with a lid. After the silicon wafer was immersed in the polishing composition at 40°C for 24 hours, the silicon wafer was immersed in ion-exchanged water for an instant, rinsed, and dried by air blow. The amount by which the weight of the air-blow dried silicon wafer was decreased before and after the immersion in the polishing composition was defined as the amount of corrosion.

**[Table 1]**

| | Polymer A (water-soluble polymer) | | | | | | | Polymer B | | Silica particles (mass%) | Mass ratio (silica particles / polymer A) | Evaluation | | | | |
|---|---|---|---|---|---|---|---|---|---|---|---|---|---|---|---|---|
| | Kind | | O derived from OH/O derived from polyoxy-alkylene | Polymerization ratio | | Weight average molecular weight | Content (mass%) | Type | Content (mass%) | | | Corrosion (mg) | Dispersed particle diameter (nm) | Wettability | Haze | LPD |
| | No. | | | PEG | PVA | | | | | | | | | | | |
| Ex.1 | 1 | Polyglycidol | 1 | - | - | 50000 | 0.010 | - | - | 0.17 | 17.0 | 1.0 | 70 | A | 0.008 | 204 |
| Com. Ex. 1 | | Polyglycidol | 1 | - | - | 50000 | 0.004 | - | - | 2.00 | 500 | 1.4 | 70 | C | 0.017 | 2307 |
| Ex. 2 | 2 | Polyglycerin | 1 | - | - | 3000 | 0.010 | - | - | 0.17 | 17.0 | 1.2 | 70 | A | 0.012 | 41 |
| Com. Ex. 2 | | Polyglycerin | 1 | - | - | 3000 | 0.004 | - | - | 2.00 | 500 | 1.5 | 70 | C | 0.030 | 1819 |
| Ex. 3 | 3 | PEG-g-PVA | 1.8 | 1 | 1.8 | 15500 | 0.020 | - | - | 0.17 | 8.5 | 0.4 | 71 | A | 0.007 | 97 |
| Ex. 4 | 4 | PEG-g-PVA | 3 | 1 | 3 | 16800 | 0.020 | - | - | 0.17 | 8.5 | 0.6 | 70 | A | 0.006 | 230 |
| Ex. 5 | 5 | PEG-g-PVA | 7 | 1 | 7 | 26000 | 0.020 | - | - | 0.17 | 8.5 | 0.7 | 70 | A | 0.005 | 219 |
| Ex. 6 | 6 | PEG-g-PVA | 2.7 | 1 | 2.7 | 26500 | 0.020 | - | - | 0.17 | 8.5 | 0.6 | 77 | A | 0.005 | 284 |
| Ex. 7 | 7 | PEG-g-PVA | 4.3 | 1 | 4.3 | 44000 | 0.005 | - | - | 0.17 | 34.0 | 0.5 | 79 | A | 0.003 | 307 |
| Ex. 8 | | PEG-g-PVA | 4.3 | 1 | 4.3 | 44000 | 0.010 | - | - | 0.17 | 17.0 | 0.5 | 80 | A | 0.003 | 213 |
| Ex. 9 | | PEG-g-PVA | 4.3 | 1 | 4.3 | 44000 | 0.020 | - | - | 0.17 | 8.5 | 0.4 | 82 | A | 0.002 | 179 |
| Ex. 10 | | PEG-g-PVA | 4.3 | 1 | 4.3 | 44000 | 0.020 | - | - | 0.10 | 5.0 | 0.4 | 82 | A | 0.002 | 165 |
| Ex. 11 | | PEG-g-PUA | 4.3 | 1 | 4.3 | 44000 | 0.020 | - | - | 0.25 | 12.5 | 0.4 | 81 | A | 0.003 | 205 |
| Ex. 12 | 8 | PEG-g-PVA | 1.1 | 1 | 1.1 | 56000 | 0.020 | - | - | 0.17 | 8.5 | 0.4 | 77 | A | 0.007 | 282 |
| Ex. 13 | 9 | PEG-p-PVA | 3 | 1 | 3 | 77000 | 0.020 | - | - | 0.17 | 8.5 | 0.4 | 84 | A | 0.003 | 210 |
| Ex. 14 | 10 | PEG-g-PVA | 4 | 1 | 4 | 103000 | 0.020 | - | - | 0.17 | 8.5 | 0.3 | 83 | A | 0.003 | 187 |
| | | | | | | | | | | | | | | | | |
| Ex. 15 | 11 | PEG-g-PVA | 7.8 | 1 | 7.8 | 155000 | 0.020 | - | - | 0.17 | 8.5 | 0.4 | 79 | A | 0.005 | 241 |
| Ex. 16 | 12 | PEG-g-PVA | 4 | 1 | 4 | 212000 | 0.020 | - | - | 0.17 | 8.5 | 0.3 | 85 | A | 0.005 | 290 |
| Ex.17 | 13 | PEG-g-PVA | 4 | 1 | 4 | 348000 | 0.020 | - | - | 0.17 | 8.5 | 0.3 | 88 | A | 0.006 | 316 |
| Com. Ex. 3 | 14 | PEG-g-PVA | 0.5 | 1 | 0.5 | 20000 | 0.020 | - | - | 0.17 | 8.5 | 0.5 | 75 | C | 0.013 | 231 |
| Com. Ex. 4 | 15 | PEG-g-PVA | 0.5 | 1 | 0.5 | 76000 | 0.020 | - | - | 0.17 | 8.5 | 0.2 | 83 | C | 0.020 | 790 |
| Com. Ex. 5 | 7 | PEG-g-PVA | 4.3 | 1 | 4.3 | 44000 | 0.004 | - | - | 2.00 | 500 | 0.8 | 79 | C | 0.012 | 2213 |
| Com. Ex. 6 | | PEG-g-PVA | 4.3 | 1 | 4.3 | 44000 | 0.050 | - | - | 2.00 | 40 | 0.5 | 81 | C | 0.010 | 2672 |
| Com. Ex. 7 | 16 | HEC | - | - | - | 800000 | 0.010 | - | - | 0.17 | 17.0 | 1.1 | 110 | A | 0.013 | 1163 |
| Com. Ex. 8 | 17 | HEC | - | - | - | 250000 | 0.010 | PEG6000 | 0.0008 | 0.17 | 17.0 | 0.5 | 94 | A | 0.008 | 531 |
| Com. Ex. 9 | 18 | PEG6000 | - | - | - | 6000 | 0.010 | - | - | 0.17 | 17.0 | 0.4 | 75 | D | 0.159 | 12318 |
| Com. Ex. 10 | 19 | PVA-105 | - | - | - | 43000 | 0.010 | - | - | 0.17 | 17.0 | 3.6 | 70 | C | 0.021 | 630 |
| Com. Ex. 11 | | PVA-105 | - | - | - | 43000 | 0.010 | PEG6000 | 0.0008 | 0.17 | 17.0 | 1.1 | 74 | D | 0.014 | 421 |

| | | | | | | | | | | | | | | | | |
|---|---|---|---|---|---|---|---|---|---|---|---|---|---|---|---|---|
| *Ex.: Example * Com. Ex.: Comparative Example | | | | | | | | | | | | | | | | |

As shown in Table 1, the polishing compositions of Examples 1-17 could reduce both of the surface roughness (haze) and the surface defects (LPD), as compared with the case of using the polishing compositions of Comprative Examples 1-11.

### Industrial Applicability

By using the polishing composition of the present invention, it is possible to reduce both of the surface roughness (haze) and the surface defects (LPD) of a silicon wafer. Therefore, the polishing composition of the present invention is useful as a polishing composition to be used in a process of manufacturing various semiconductor substrates, and in particular, it is useful as a polishing composition for a final polishing of a silicon wafer.

## Claims

1. A polishing composition for a silicon wafer, comprising:
0.01 to 0.5 mass% of silica particles;
a nitrogen-containing basic compound; and
a water-soluble polymer,
wherein the water-soluble polymer includes a constitutional unit represented by a general formula (1) below: 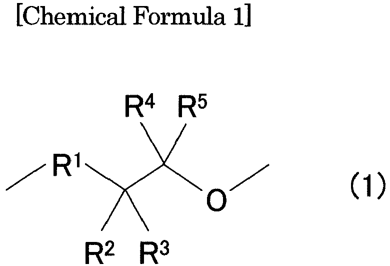 (wherein, in the above general formula (1),
R¹ is a methylene group (-CH₂-) or a bond, and
R², R³, R⁴ and R⁵ each independently represent H (hydrogen atom), -OH (hydroxyl group), -CH₂OH or polyvinyl alcohol, where all of R², R³, R⁴ and R⁵ do not simultaneously represent H (hydrogen atom), -OH (hydroxyl group) or -CH₂OH), and
in the water-soluble polymer, a ratio of the number of oxygen atoms derived from hydroxyl groups to the number of oxygen atoms derived from polyoxyalkylene (the number of oxygen atoms derived from hydroxyl groups / the number of oxygen atoms derived from polyoxyalkylene) is in a range from 0.8 to 10.

2. The polishing composition for a silicon wafer according to claim 1, wherein the water-soluble polymer is a polyvinyl alcohol-polyethylene glycol graft copolymer.

3. The polishing composition for a silicon wafer according to claim 2, wherein a weight average molecular weight of the polyvinyl alcohol-polyethylene glycol graft copolymer is in a range from 10,000 to 150,000.

4. The polishing composition for a silicon wafer according to claim 1, wherein the water-soluble polymer is polyglycidol and/or a polyglycidol derivative.

5. The polishing composition for a silicon wafer according to claim 4, wherein weight average molecular weights of the polyglycidol and polyglycidol derivative are in a range from 3,000 to 150,000.

6. The polishing composition for a silicon wafer according to claim 1, wherein the water-soluble polymer is polyglycerin and/or a polyglycerin derivative.

7. The polishing composition for a silicon wafer according to claim 6, wherein weight average molecular weights of the polyglycerin and polyglycerin derivative are in a range from 500 to 50,000.

8. The polishing composition for a silicon wafer according to any one of claims 1 to 7, wherein a mass ratio of the silica particles to the water-soluble polymer (a mass of the silica particles / a mass of the water-soluble polymer) is in a range from 1 to 38.

9. A method for polishing a silicon wafer, comprising a step of polishing a silicon wafer using the polishing composition for a silicon wafer according to any one of claims 1 to 8.

10. A method for manufacturing a semiconductor substrate, comprising a step of polishing a silicon wafer using the polishing composition for a silicon wafer according to any one of claims 1 to 8.
